Europäisches Patentamt

European Patent Office

Office européen des brevets

(19)

(11)  EP 1 019 824 B1

(12)  **EUROPÄISCHE PATENTSCHRIFT**

(45) Veröffentlichungstag und Bekanntmachung des Hinweises auf die Patenterteilung:
**12.12.2001  Patentblatt 2001/50**

(21) Anmeldenummer: **98949871.2**

(22) Anmeldetag: **30.07.1998**

(51) Int Cl.7: **G06F 11/16**

(86) Internationale Anmeldenummer:
**PCT/DE98/02291**

(87) Internationale Veröffentlichungsnummer:
**WO 99/06911 (11.02.1999 Gazette 1999/06)**

(54) **VERFAHREN ZUM ERZEUGEN EINES FEHLERKENNZEICHNUNGSSIGNALS IM DATENBESTAND EINES SPEICHERS UND HIERZU GEEIGNETE EINRICHTUNG**

METHOD FOR GENERATING AN ERROR IDENTIFICATION SIGNAL IN THE DATA INVENTORY OF A MEMORY, AND DEVICE DESIGNED FOR THAT PURPOSE

PROCEDE POUR PRODUIRE UN SIGNAL D'IDENTIFICATION D'ERREURS DANS LE RECENSEMENT DES DONNEES D'UNE MEMOIRE ET DISPOSITIF APPROPRIE A CET EFFET

(84) Benannte Vertragsstaaten:
**AT DE**

(30) Priorität: **31.07.1997  DE 19734554**

(43) Veröffentlichungstag der Anmeldung:
**19.07.2000  Patentblatt 2000/29**

(73) Patentinhaber: **SIEMENS AKTIENGESELLSCHAFT**
**80333 München (DE)**

(72) Erfinder:
- **EUE, Wolfgang**
  **D-38162 Cremlingen (DE)**
- **GRONEMEYER, Michael**
  **D-38162 Cremlingen (DE)**
- **SCHÖNFELDER, Andreas**
  **D-38642 Goslar (DE)**

(56) Entgegenhaltungen:
**EP-A- 0 323 123          EP-A- 0 636 984**
**DE-A- 3 619 174          US-A- 3 544 777**

**Beschreibung**

Die Erfindung bezieht sich auf ein Verfahren nach dem Oberbegriff des Anspruches 1 sowie auf eine hierzu geeignete Einrichtung.

Aus der DE Zeitschrift "SIGNAL + DRAHT", 84 (1992) 1/2, Seiten 10 bis 13, "SIMIS 3116 - Sicheres Microcomputersystem für den Fahrzeugeinsatz" ist ein Datenverarbeitungssystem bekannt, bei dem zwei oder drei Mikroprozessoren zur Steuerung eines an sich beliebigen Prozesses gleiche Programme synchron bearbeiten, wobei jeder der Mikroprozessoren einen eigenen Speicher aufweist. Die zwei bzw. drei Mikroprozessoren sind mit einer Steueranordnung in Form eines Voters mit vorgeschalteten Vergleichern verbunden. Die Vergleicher und der Voter vergleichen die Ausgabeinformationen der Mikroprozessoren, wobei bei Ungleichheit der Ausgabeinformationen auf einen Fehler geschlossen und ggf. eine Sicherheitsabschaltung vorgenommen wird. Bei der bekannten Anordnung wird ein Fehler anhand der Ausgabeinformationen der Mikroprozessoren erkannt; eine Unterscheidung zwischen einem Speicherfehler und einem Verarbeitungsfehler ist nicht möglich.

Aus dem Buch "Mikroprozessoren, Aufbau und Wirkungsweise" des Autors Werner Kobitzsch (R. Oldenbourg-Verlag, 1981, Seiten 68 bis 74, insbesondere Seiten 70, 71 und 73) ist es bekannt, daß Daten von einem Mikroprozessor in einem freiprogrammierbaren Speicher gespeichert und anschließend aus diesem wieder gelesen werden können. Hierzu werden zwischen dem Mikroprozessor und dem Speicher Datensignale über einen Datenbus, Adreßsignale über einen Adreßbus und Steuersignale über einen Steuerbus übertragen.

Aus der EP 0 636 984 A1 sind ein Verfahren und eine Einrichtung zum Erzeugen eines Fehlersignals zur Kennzeichnung eines Fehlers im Datenbestand des Speichers eines Mikrocomputers bekannt, bei dem bzw. bei der Daten in unterschiedlichen Speichern mehrfach abgelegt werden. Die einander entsprechenden Daten sollen zum Auffinden von aus den Speichern entnehmbaren fehlerhaften Daten miteinander verglichen werden. Dies geschieht in einer Steuereinheit außerhalb des Mikrocomputers/Mikroprozessors, in dem die Daten verarbeitet werden sollen. Die Steuereinheit ist hierzu mit mehreren Vergleichern und mit einer entsprechenden Ansteuerung ausgerüstet; ein hoher Aufwand hierfür vermindert die erreichbare Zuverlässigkeit des Mikrocomputersystems insgesamt, zumindest aber die Zuverlässigkeit der Fehlererkennung.

Der Erfindung liegt die Aufgabe zugrunde, ein Verfahren zum Erkennen von fehlerhaften Daten in den Speichern eines Mikrocomputers oder Mikroprozessors anzugeben, mit dem solche Fehler zuverlässiger als bisher erkannt werden können; es ist ferner Aufgabe der Erfindung, eine hierzu geeignete Einrichtung anzugeben.

Diese Aufgabe wird erfindungsgemäß durch die kennzeichnenden Merkmale des Anspruchs 1 bzw. die des Anspruches 6 gelöst.

Der wesentliche Vorteil der erfindungsgemäßen Anordnung besteht darin, daß durch die Verwendung von zwei Speichern in der mindestens einen Mikrocomputer/Mikroprozessoranordnung in Verbindung mit dem vorgesehenen Datenvergleich eine größere Datensicherheit als bei Verwendung nur eines Speichers erreicht werden kann; bei jedem Abspeichern von Daten werden inhaltlich übereinstimmende Daten in der mindestens einen Mikroprozessoranordnung in getrennten Speichern abgespeichert, so daß beim späteren Lesen der Daten aus den beiden Speichern von dem jeweiligen Mikroprozessor ein Datenvergleich durchgeführt werden kann; bei Ungleichheit der jeweiligen Daten ist so ein Datenfehler erkennbar. Speicherfehler werden in dieser Weise also bereits erkannt, bevor der jeweilige Mikroprozessor die fehlerhaften Daten verarbeitet. Darüber hinaus können bei der erfindungsgemäßen Anordnung durch die Verwendung einer Steuereinheit in der mindestens einen Mikroprozessoranordnung die zwei Speicher gleichzeitig beschrieben werden, was zu einer Zeitersparnis von 50% gegenüber einem zeitlich aufeinanderfolgenden, getrennten Abspeichern in beiden Speichern führt.

Besonders einfach und damit vorteilhaft läßt sich die Erfindung realisieren, wenn in der mindestens einen Mikroprozessoranordnung auf Busanschlüsse wie Datenbus-, Adreßbus- und Steuerbusanschlüsse bei der Steuereinheit verzichtet wird. Dies läßt sich in vorteilhafter Weise dadurch erreichen, daß die Steuereinheit in der mindestens einen Mikroprozessoranordnung lediglich über eine Steuerleitung, eine weitere Steuerleitung und eine Kontrolleitung an den Mikroprozessor angeschlossen ist. Die beiden Steuerleitungen können dabei beispielsweise an sogenannte "memory chip select"-Ausgänge oder an frei programmierbare "output ports" des Mikroprozessors angeschlossen sein. Die Kontrolleitung kann beispielsweise eine "read/write" ("CPU-Status-Lesen/Schreiben-Nicht")-Leitung des Mikroprozessors sein.

Es sei an dieser Stelle darauf hingewiesen, daß ein Umschalten von "output ports" deutlich mehr Zeit kostet als ein Umschalten von "memory chip select"-Ausgängen; es wird daher im Rahmen einer Weiterbildung der Erfindung als vorteilhaft erachtet, wenn mindestens eine der beiden Steuerleitungen an einen "memory chip select"-Ausgang des Mikroprozessors angeschlossen ist, um eine hohe Arbeitsgeschwindigkeit der erfindungsgemäßen Anordnung zu erreichen.

Die Steuereinheit läßt sich kostengünstig beispielsweise aus logischen Gattern in Form von Standard-IC's zusammensetzen; es wird also als vorteilhaft angesehen, wenn die Steuereinheit in der mindestens einen Mikroprozessoranordnung ein ODER-Glied, ein UND-Glied und einen Inverter enthält, wobei der Inverter eingangsseitig mit der Kontrolleitung und ausgangsseitig mit einem Eingang des UND-Gliedes verbunden ist, ein weiterer Eingang des UND-Gliedes an die eine Steuerleitung angeschlossen ist, dem UND-Glied und der weiteren Steuerleitung das ODER-Glied nachgeschaltet ist, das ausgangsseitig an die weitere Speicherauswahlleitung angeschlossen ist, und die eine Steuerleitung mit der einen Speicherauswahlleitung in Verbindung steht.

Um in der mindestens einen Mikroprozessoranordnung beide Speicher auslesen zu können, ist jeweils von einem der beiden Speicher auf den jeweils anderen der beiden Speicher umzuschalten. Dies läßt sich durch eine entsprechende Programmierung des Mikroprozessors erreichen, was jedoch den Mikroprozessor belastet und die Arbeitsgeschwindigkeit der mindestens einen Mikroprozessoranordnung reduziert. Um eine möglichst hohe Arbeitsgeschwindigkeit zu erreichen, sollte der Mikroprozessor in der mindestens einen Mikroprozessoranordnung von diesem Umschalten entlastet werden; dies läßt sich erreichen, wenn die Speicher nach jedem Lesevorgang automatisch von der Steuereinheit gewechselt werden. Es wird also als vorteilhaft erachtet, wenn in der mindestens einen Mikroprozessoranordnung an eine Lesesteuerleitung eines den Mikroprozessor und die beiden Speicher verbindenden Steuerbusses die Steuereinheit eingangsseitig angeschlossen ist, die nach dem Auslesen des jeweils einen der beiden Speicher den jeweils anderen der beiden Speicher aktiviert.

Besonders einfach und damit vorteilhaft läßt sich das Signal auf der Lesesteuerleitung lesen, wenn die Steuereinheit an die Lesesteuerleitung des Steuerbusses über ein Toggle-Flip-Flop angeschlossen ist, das sein an die Steuereinheit gerichtetes binäres Ausgangssignal nach jedem Potentialwechsel auf der Lesesteuerleitung ändert.

Zur Erläuterung der Erfindung zeigt

Figur 1     ein Ausführungsbeispiel einer erfindungsgemäßen Anordnung mit einer Steueranordnung und zwei Mikroprozessoranordnungen in einer Prinzipdarstellung,

Figur 2     ein Blockschaltbild eines Ausführungsbeispieles einer in der erfindungsgemäßen Anordnung gemäß Figur 1 enthaltenen Mikroprozessoranordnung,

Figur 3     ein Ausführungsbeispiel für eine Steuereinheit in der Mikroprozessoranordnung gemäß Figur 2,

Figur 4     eine das elektrische Steuerverhalten der Steuereinheit gemäß Figur 3 beschreibende Wahrheitstabelle,

Figur 5     ein weiteres Ausfuhrungsbeispiel für eine in der erfindungsgemaßen Anordnung gemäß Figur 1 enthaltene Mikroprozessoranordnung,

Figur 6     ein Ausführungsbeispiel für eine Steuereinheit in der Mikroprozessoranordnung gemäß Figur 5,

Figur 7     eine das elektrische Steuerverhalten der Steuereinheit gemäß Figur 6 beschreibende Wahrheitstabelle,

Figur 8     ein weiteres Ausführungsbeispiel für eine Steuereinheit in der Mikroprozessoranordnung gemäß Figur 2 und

Figur 9     eine das Steuerverhalten der Steuereinheit gemäß Figur 8 beschreibende Wahrheitstabelle.

In den Figuren werden für technisch gleichartige Elemente die gleichen Bezugszeichen verwendet. In der nachfolgenden Beschreibung steht der Ausdruck Mikroprozessor auch für den Begriff Mikrocomputer.

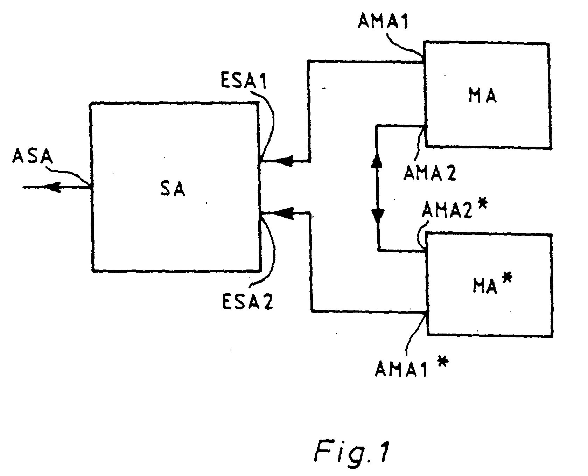

Figur 1 zeigt eine elektronische Anordnung bestehend aus zwei Mikroprozessoranordnungen MA, MA* und einer Steueranordnung SA. Die Ausgänge AMA1, AMA1* der beiden Mikroprozessoranordnungen MA, MA* sind mit den Eingängen ESA1 bzw. ESA2 der Steueranordnung SA verbunden. Die beiden Mikroprozessoranordnungen MA, MA* weisen jeweils einen weiteren Ausgang AMA2, AMA2*, auf; diese sind untereinander verbunden.

Die Anordnung gemäß Figur 1 stellt ein Hikrsprozessorsystem dar, das eine hohe Sicherheit gewährleistet und beispielsweise zur Steuerung von Schienenfahrzeugen eingesetzt werden kann. Hierzu werden die beiden Mikroprozessoranordnungen MA, MA* mit identischen Softwareprogrammen oder mit hinsichtlich ihrer Funktion gleichwirkenden Softwareprogrammen betrieben. Die beiden Mikroprozessoranordnungen MA, MA* tauschen wahrend der Abarbeitung ihrer jeweiligen Softwareprogramme über ihre weiteren Ausgange AMA2, AMA2* wichtige Ergebnisse oder Zwischenergebnisse bei ihren Berechnungen aus, so daß Abweichungen und damit aufgetretene Fehler von den Mikroprozessoranordnungen MA, MA* durch internen Datenvergleich selbst erkannt werden konnen. Die Steueranordnung SA soll verhindern, daß ein fehlerhaftes Ausgangssignal einer defekten Mikroprozessoranordnung MA, MA*, auf den zu steuernden Prozeß gelangen kann; sie vergleicht die Ausgangssignale an den einen Ausgängen AMA1, AMA1* der Mikroprozessoranordnungen MA, MA* und leitet diese nur dann an ihren Ausgang ASA weiter, wenn die Ausgangssignale übereinstimmen. Bei der Anordnung gemäß Figur 1 handelt es sich um ein schwach gekoppeltes Doppelrechnersystem. Die Steueranordnung SA kann im einfachsten Fall ein UND-Glied sein.

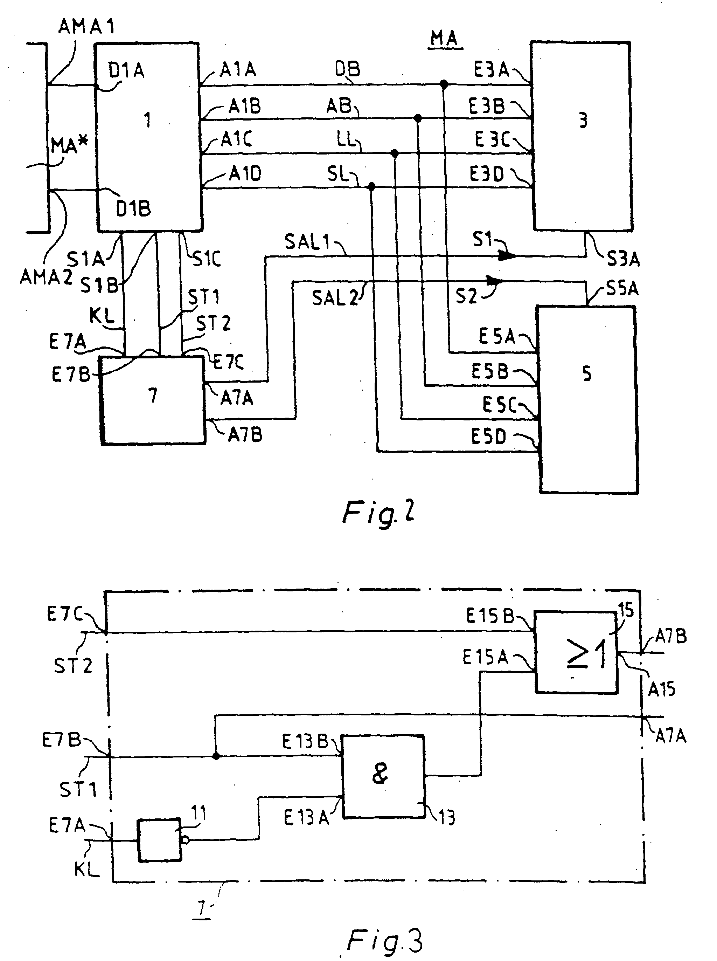

Um eine besonders hohe Sicherheit der Anordnung gemäß Figur 1 zu erzielen, sind die beiden Mikroprozessoranordnungen MA, MA*, erfindungsgemäß anstatt jeweils nur mit einem jeweils mit zwei Speichern ausgerüstet; abzuspeichernde Daten werden von den Mikroprozessoranordnungen jeweils in beiden Speichern abgespeichert, so daß jede der Mikroprozessoranordnungen beim Auslesen der Daten aus den jeweiligen beiden Speichern die ausgelesenen Daten auf Gleichheit hin untersuchen kann. Stellt dabei eine der beiden Mikroprozessoranordnungen eine Datenabweichung fest, so wird eine Sicherheitsreaktion ausgelöst. Die detaillierte Beschreibung der beiden Mikroprozessoranordnungen erfolgt im Zusammenhang mit der Figur 2.

Figur 2 zeigt eine Mikroprozessoranordnung MA mit einem Mikroprozessor 1, der mit einem Ausgang A1A über einen Datenbus DB mit einem Eingang E3A eines Speichers 3 verbunden ist. Zusätzlich zu dem Datenbus DB bestehen weitere elektrische Verbindungen zwischen dem Mikroprozessor 1 und dem Speicher 3, nämlich in Form eines Adreßbusses AB zwischen einem weiteren Ausgang A1B des Mikroprozessors 1 und einem weiteren Eingang E3B des Speichers 3, einer Lesesteuerleitung LL zwischen einem zusätzlichen Ausgang A1C des Mikroprozessors 1 und einem zusätzlichen Eingang E3C des Speichers 3 und einer Schreibsteuerleitung SL zwischen einem ergänzenden Ausgang A1D des Mikroprozessors 1 und einem ergänzenden Eingang E3D des Speichers 3.

Dem Speicher 3 parallelgeschaltet ist ein weiterer Speicher 5, dessen einer Eingang E5A mit dem einen Eingang E3A des einen Speichers 3 und damit mit dem Datenbus DB verbunden ist. Ein weiterer Eingang E5B des weiteren Speichers 5 ist an den Adreßbus AB und damit an den weiteren Eingang E3B des Speichers 3 angeschlossen. Ein zusätzlicher Eingang E5C des weiteren Speichers 5 ist mit dem zusätzlichen Eingang E3C des einen Speichers 3 und damit mit der Lesesteuerleitung LL verbunden, und ein ergänzender Eingang E5D des weiteren Speichers 5 ist über die Schreibsteuerleitung SL dem ergänzenden Eingang E3D des einen Speichers 3 parallelgeschaltet. Die Schreibsteuerleitung SL und die Lesesteuerleitung LL bilden dabei einen Steuerbus.

Figur 2 zeigt außerdem eine Steuereinheit 7, die mit ihrem Steuereingang E7A über eine Kontrolleitung KL mit einem Steuerausgang S1A des Mikroprozessors 1 verbunden ist. Ein weiterer Steuerausgang S1B des Mikroprozessors 1 ist über eine Steuerleitung ST1 an einen weiteren Steuereingang E7B der Steuereinheit 7 angeschlossen; ein zusätzlicher Steuerausgang S1C des Mikroprozessors 1 ist über eine weitere Steuerleitung ST2 an einen zusätzlichen Steuereingang E7C der Steuereinheit 7 angeschlossen. Ausgangsseitig ist die Steuereinheit 7 über einen Ausgang A7A mit einem Steuereingang S3A des einen Speichers 3 und über einen weiteren Ausgang A7B mit einem Steuereingang S5A des weiteren Speichers 5 verbunden; die Verbindung zwischen der Steuereinheit 7 und dem einen Speicher 3 wird dabei durch die eine Speicherauswahlleitung SAL1 hergestellt, die Verbindung zwischen der Steuereinheit 7 und dem weiteren Speicher 5 durch eine weitere Speicherauswahlleitung SAL2.

Der Mikroprozessor 1 ist über einen Datenausgang D1A mit dem einen Ausgang AMA1 der Mikroprozessoranordnung MA* und über einen weiteren Datenausgang D1B mit dem weiteren Ausgang AMA2 der Mikroprozessoranordnung MA* verbunden.

Der weitere Steuerausgang S1B und der zusätzliche Steuerausgang S1C des Mikroprozessors 1 können beispielsweise "memory chip select"-Ausgänge oder sogenannte "output ports" des Mikroprozessors 1 sein. Falls es sich bei mindestens einem der beiden Steuerausgängen S1B oder S1C des Mikroprozessors 1 um einen "output port"-Ausgang handelt, so hängt die durch die Steuereinheit 7 zu realisierende logische Verknüpfung von der jeweiligen Programmierung des Mikroprozessors 1 ab. Bei den weiteren Erläuterungen zu Figur 2 und anschließend zu den Figuren 3 bis 7 wird zunächst einmal davon ausgegangen, daß es sich bei den Steuerausgängen S1B und S1C ausschließlich um "memory chip select"-Ausgänge handelt; diese weisen die Eigenschaft auf, daß zu jedem Zeitpunkt jeweils nur einer dieser Ausgänge eine logische "1" aufweist.

Mit der Mikroprozessoranordnung gemäß Figur 2 lassen sich Daten abspeichern und lesen; dabei können die Daten

- gleichzeitig in den beiden Speichern 3 und 5 abgespeichert werden,
- nur in dem weiteren Speicher 5 abgespeichert werden,
- aus dem einen Speicher 3 gelesen werden oder
- aus dem weiteren Speicher 5 gelesen werden.

Mit der Mikroprozessoranordnung MA nach Figur .2 läßt sich eine besonders hohe Datensicherheit erreichen, wenn die Daten vorzugsweise gleichzeitig in beiden Speichern 3 und 5 abgespeichert werden und wenn bei einem anschließenden Lesen der Daten aus den beiden Speichern 3 und 5 ein Datenvergleich durchgeführt wird. Dieser Vergleich erfolgt im Mikroprozessor 1. Falls sich die Daten aus den beiden Speichern 3 und 5 unterscheiden, so ist ein Lese- oder Schreibfehler beim Lesen bzw. Abspeichern der Daten aufgetreten, und es wird vom Mikroprozessor 1 ein entsprechendes Fehlerkennzeichnungssignal an den Datenausgängen D1A und D1B erzeugt; gegebenenfalls kann ein Lesefehler durch ein erneutes Lesen der Daten behoben werden.

Die Mikroprozessoranordnung nach Figur 2 ermöglicht es außerdem, daß der Mikroprozessor 1 zu Testzwecken z. B. in dem Speicher 5 andere Daten als in dem Speicher 3 abspeichert; der vom Mikroprozessor 1 beim Lesen der Daten durchgeführte Datenvergleich führt in diesem Fall nur dann zur Abgabe des Fehlerkennzeichnungssignals, wenn die Daten der beiden Speicher wider Erwarten gleich sind.

Zum Abspeichern bzw. Lesen der Daten werden entsprechende Datensignale über den Datenbus DB zwischen dem Mikroprozessor 1 und den beiden Speichern 3 und 5 übertragen. An den Adreßbus AB wird vom Mikroprozessor 1 ein Adreßsignal angelegt, das die entsprechende Speicheradresse in dem einen Speicher 3 bzw. in dem weiteren Speicher 5 bestimmt. Zum Lesen wird über die Lesesteuerleitung LL eine logische "1" und über die Schreibsteuerleitung SL eine logische "0" übertragen; zum Abspeichern von Daten ist dies umgekehrt, d. h. über die Lesesteuerleitung LL wird eine logische "0" und über die Schreibsteuerleitung SL eine logische "1" übermittelt. Zusätzlich müssen die beiden Speicher 3 und 5 zum Lesen oder Abspeichern noch aktiviert werden; dies geschieht mit den Aktivierungssignalen S1 und S2 über die Speicherauswahlleitungen SAL1 und SAL2 in nachfolgend beschriebener Weise:

Abspeichern von Daten:

Beim Abspeichern von Daten werden zwei Betriebsarten unterschieden: Bei der einen werden die Daten gleichzeitig in beiden Speichern 3 und 5 abgespeichert, bei der anderen ausschließlich in dem weiteren Speicher 5. Ein Abspeichern von Daten in dem einen Speicher 3 ist bei diesem Ausführungsbeispiel nicht vorgesehen.

1. Gleichzeitiges Abspeichern:

Sollen die Daten gleichzeitig sowohl in dem einen Speicher 3 als auch in dem weiteren Speicher 5 abgespeichert werden, so wird der Steuereinheit 7 vom Mikroprozessor 1 über die eine Steuerleitung ST1 eine logische "1", über die weitere Steuerleitung ST2 eine logische "0" und über die Kontrolleitung KL eine logische "0" übermittelt. Dabei bedeutet eine logische "0" auf der Kontrolleitung KL, daß Daten abgespeichert werden sollen. Die Steuereinheit 7 erzeugt daraufhin ein Aktivierungssignal S1 mit einer logischen "1" auf der einen Speicherauswahlleitung SAL1 und ein weiteres Aktivierungssignal S2 ebenfalls mit einer logischen "1" auf der weiteren Speicherauswahlleitung SAL2. Die Funktionsweise der Steuereinheit 7 wird im Zusammenhang mit den Figuren 3 bis 9 erläutert. Die Speicher 3 und 5 werden durch eine logische "1" an ihren Steuereingängen S3A und S5A aktiviert.

2. Abspeichern von Daten im weiteren Speicher 5:

Soll ausschließlich der weitere Speicher 5 mit Daten beschrieben werden, so wird der Steuereinheit 7 über die eine Steuerleitung ST1 eine logische "0", über die weitere Steuerleitung ST2 eine logische "1" und über die Kontrolleitung KL eine logische 0 übermittelt. In der Steuereinheit 7 werden daraufhin ein Aktivierungssignal S1 mit einer logischen "0" für den einen Speicher 3 und ein weiteres Aktivierungssignal S2 mit einer logischen "1" für den weiteren Speicher 5 erzeugt, so daß in diesem Fall ausschließlich der weitere Speicher 5 aktiviert ist.

Die Funktion der Steuereinheit 7 besteht also im wesentlichen darin, die eingangsseitig an dem weiteren Steuereingang E7B und dem zusätzlichen Steuereingang E7C anliegenden Signale gewünschtenfalls derart umzukodieren, daß ein gleichzeitiges Beschreiben der beiden Speicher 3 und 5 ermöglicht wird; die Steuereinheit 7 wird zu diesem Zweck benötigt, weil, wie bereits beschrieben, von dem weiteren Steuerausgang S1B und dem zusätzlichen Steuerausgang S1C des Mikroprozessors 1 zu jedem Zeitpunkt jeweils nur einer eine logische "1" aufweisen kann; denn es handelt sich bei diesen Steuerausgängen S1B und S1C annahmegemäß um "memory chip select"-Ausgänge.

Lesen von Daten:

Das Lesen von Daten aus dem einen Speicher 3 oder aus dem weiteren Speicher 5 wird folgendermaßen durchgeführt:

1. Lesen aus dem einen Speicher 3:

Sollen Daten aus dem einen Speicher 3 gelesen werden, so wird vom Mikroprozessor 1 über die eine Steuerleitung ST1 eine logische "1" zur Steuereinheit 7 übertragen; über die weitere Steuerleitung ST2 wird eine logische "0" übermittelt. Mit der Kontrolleitung KL wird, da es sich um einen Lesevorgang handelt, eine logische "1" zur Steuereinheit 7 übertragen. In der Steuereinheit 7 werden aus den eingangsseitig anliegenden Signalen das eine Aktivierungssignal S1 für den einen Speicher 3 und das weitere Aktivierungssignal S2 für den weiteren Speicher 5 erzeugt; dabei weist das eine Aktivierungssignal S1 eine logische "1" und das weitere Aktivierungssignal S2 in diesem Fall eine logische "0" auf, da der eine Speicher 3 aktiviert und der weitere Speicher 5 deaktiviert werden soll.

2. Lesen aus dem weiteren Speicher 5:

Sollen die Daten aus dem weiteren Speicher 5 gelesen werden, so wird von dem Mikroprozessor 1 über die eine Steuerleitung ST1 eine logische "0" und über die weitere Steuerleitung ST2 eine logische "1" an die Steuereinheit 7 übermittelt. Mit der Kontrolleitung KL wird - es handelt sich um einen Lesevorgang - eine logische "1" zur Steuereinheit 7 übertragen. In der Steuereinheit 7 wird aus den eingangsseitig anliegenden Signalen das eine Aktivierungssignal ST1 mit einer logischen "0" zum Deaktivieren des einen Speichers 3 und das weitere Aktivierungssignal S2 mit einer logischen "1" zum Aktivieren des weiteren Speichers 5 erzeugt.

Wie oben bereits im einzelnen dargelegt, werden die aus den Speichern 3 und 5 gelesenen Daten im Mikroprozessor 1 auf Übereinstimmung verglichen und daraus gegebenenfalls das Fehlerkennzeichnungssignal gebildet. Dieses Vergleichen kann grundsätzlich bei jedem Auslesen von Daten durchgeführt werden. Eine höhere Arbeitsgeschwindigkeit der Mikroprozessoranordnung MA läßt sich jedoch erreichen, wenn das Vergleichen von Daten von der "normalen" Prozeßbearbeitung abgetrennt wird, d. h. wenn das Vergleichen separat durchgeführt wird; beispielsweise kann das Vergleichen im Rahmen eines Testprogrammes durchgeführt werden, das den gesamten Speicherinhalt der beiden Speicher 3 und 5 systematisch miteinander vergleicht und bei Unterschieden zwischen den ausgelesenen Daten der beiden Speicher ein Fehlersignal erzeugt. Ein solches Testprogramm wird unter Berücksichtigung festgelegter maximaler Folgezeiten vorteilhafterweise immer dann aktiviert, wenn der Mikroprozessor 1 keine anderen Prozesse zu bearbeiten hat; das Testprogramm läuft damit also im Hintergrund.

Bei dem Testprogramm kann darüber hinaus vorgesehen sein, daß die Daten aus den beiden Speichern 3 und 5 nicht einzeln sondern "blockweise" verglichen werden. Konkret kann dies beispielsweise in der Weise geschehen, daß zunächst nur Daten aus dem einen Speicher 3 unter Bildung eines Datenblocks ausgelesen werden. Aus den Daten dieses Datenblocks wird mittels eines bekannten Kodierverfahrens anschließend eine Signatur (Checksumme) gebildet. In einem weiteren Schritt werden - in gleicher Weise wie bei den Daten aus dem einen Speicher 3 - dann die entsprechenden Daten aus dem weiteren Speicher 5 unter Bildung einer weiteren Signatur ausgelesen. Zum Datenvergleich werden dann ausschließlich die Signaturen verglichen; unterscheiden sich die Signaturen, so ist mindestens ein Datenfehler aufgetreten.

Um eine besonders hohe Sicherheit gegen Datenverfälschungen zu erreichen, können die Daten aus den beiden Speichern zunächst mittels des letztgenannten Verfahrens mit Signatur-Bildung und anschließend - bei genügend vorhandener Zeit - nochmals einzeln verglichen werden.

Figur 3 zeigt ein Ausführungsbeispiel für die Steuereinrichtung 7 der Mikroprozessoranordnung MA gemäß Figur 2. Man erkennt einen Inverter 11, der eingangsseitig mit dem einen Steuereingang E7A der Steuereinheit 7 und damit mit der Kontrolleitung KL verbunden ist. Dem Inverter 11 nachgeschaltet ist ein UND-Glied 13 mit einem Eingang E13A. Einem weiteren Eingang E13B des UND-Gliedes 13 ist der weitere Steuereingang E7B der Steuereinheit 7 und damit die eine Steuerleitung ST1 vorgeschaltet. Ausgangsseitig ist das UND-Glied 13 an einen Eingang E15A eines ODER-Gliedes 15 angeschlossen, dessen weiterer Eingang E15B mit dem zusätzlichen Steuereingang E7C der Steuereinheit 7 und damit mit der weiteren Steuerleitung ST2 verbunden ist. Das ODER-Glied 15 bildet mit seinem Ausgang A15 den weiteren Ausgang A7B der Steuereinheit 7. Der eine Ausgang A7A der Steuereinheit 7 ist direkt mit dem weiteren Steuereingang E7B der Steuereinheit 7 verbunden.

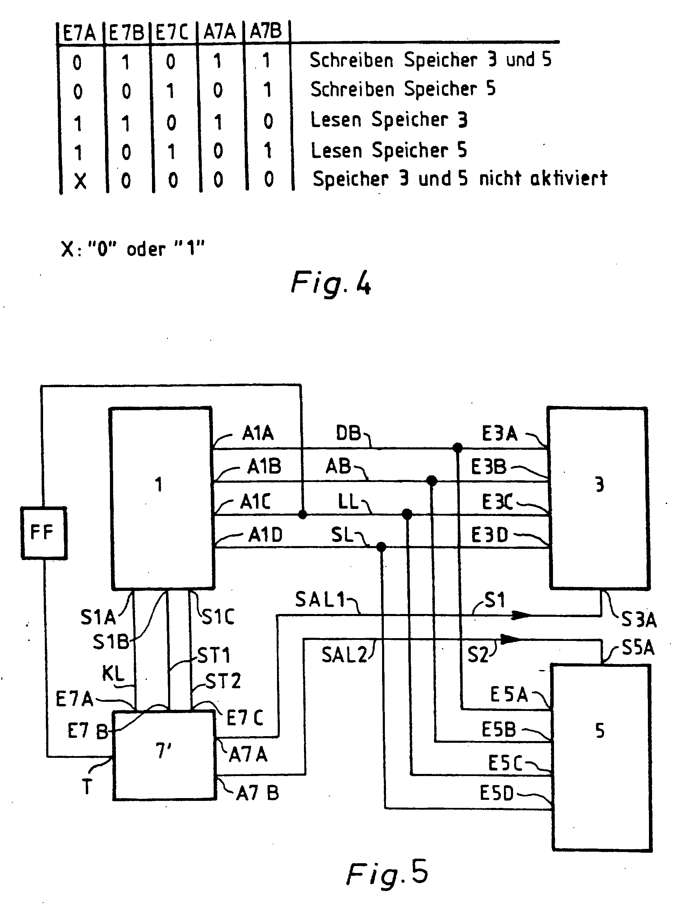

Die durch die Steuereinheit 7 hergestellte logische Verknupfung läßt sich der Tabelle in Figur 4 entnehmen. Die Funktion der Steuereinheit 7 besteht im wesentlichen in einem Umkodieren der eingangsseitig anliegenden Signale, un ein gleichzeitiges Abspeichern von Daten in beiden Speichern 3 und 5 gemäß Figur 2 zu erreichen. Dieses Umkodieren ist zur Realisierung der vorgenannten Funktion erforderlich, da es sich bei dem weiteren Steuerausgang S1B und dem zusätzlichen Steuerausgang S1C des Mikroprozessors 1 gemäß Figur 2 um "memory chip select"-Ausgänge handelt, von denen jeweils nur ein Ausgang eine logische 1 aufweisen kann. Außerdem ermöglicht die Steuereinheit 7 aber auch ein getrenntes Beschreiben des weiteren Speichers 5; dies ist insbesondere dann nötig, wenn zu Testzwecken die beiden Speicher 3 und 5 mit unterschiedlichen Daten beschrieben werden sollen.

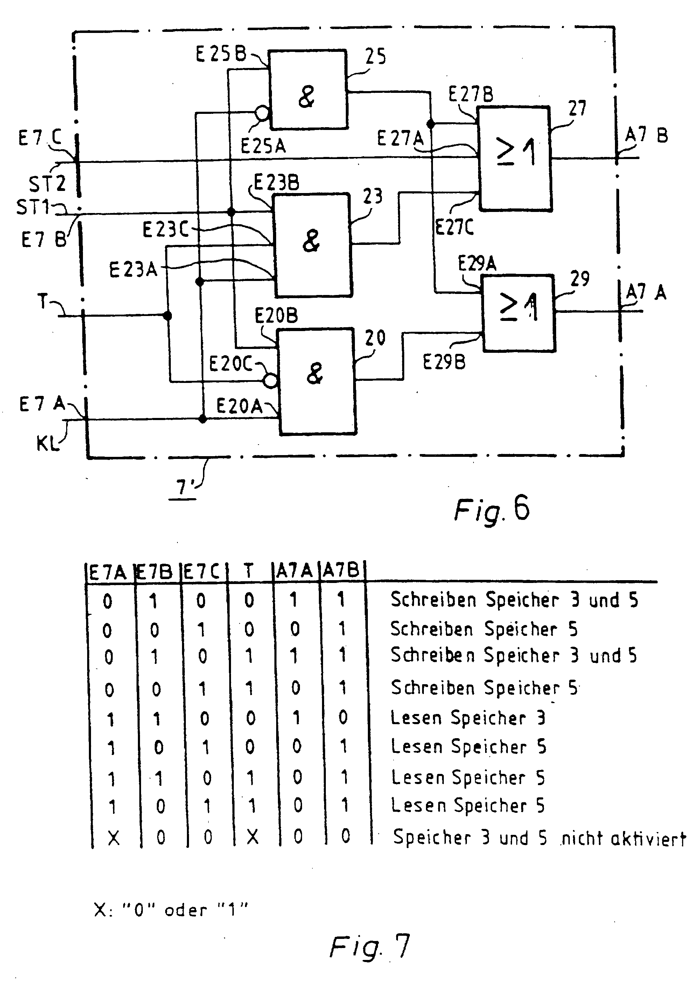

Die Mikroprozessoranordnung MA gemäß Figur 5 entspricht fast vollständig der Mikroprozessoranordnung gemäß Figur 2; im Unterschied zur Anordnung gemäß Figur 2 ist bei der Anordnung gemäß Figur 5 die Steuereinheit 7' mit einem Toggleeingang T zusätzlich über ein Toggle-Flip-Flop FF an die Lesesteuerleitung LL des Steuerbusses angeschlossen. Die übrige Beschaltung des Mikroprozessors 1, des einen Speichers 3 und des weiteren Speichers 5 entspricht der bei der Anordnung gemäß Figur 2.

Der Vorteil dieser Beschaltung der Steuereinheit 7' wird im Zusammenhang mit den Figuren 6 und 7 diskutiert.

Figur 6 zeigt ein Ausführungsbeispiel für eine Steuereinheit 7' gemäß Figur 5. Der eine Steuereingang E7A der Steuereinheit 7' und damit die Kontrolleitung KL sind mit einem Eingang E20A eines weiteren UND-Gliedes 20, mit einem Eingang E23A eines zusätzlicher UND-Gliedes 23 und mit einem invertierenden Eingang E25A eines erganzenden UND-Gliedes 25 verbunden. Der weitere Steuereingang E7B der Steuereinheit 7' und damit die eine Steuerleitung ST1 sind mit einem weiteren Eingang E20B des weiteren UND-Gliedes 20, mit einem weiteren Eingang E23B des zusätzlichen UND-Gliedes 23 und mit einem Eingang E25B des ergänzenden UND-Gliedes 25 verbunden. Der zusätzliche Steuereingang E7C der Steuereinheit 7' und die weitere Steuerleitung ST2 sind an einen Eingang E27A eines weiteren ODER-Gliedes 27 angeschlossen. Dem ergänzenden UND-Glied 25 ausgangsseitig nachgeordnet sind ein weiterer Eingang E27B des weiteren ODER-Gliedes 27 und ein Eingang E29A eines zusätzlichen ODER-Gliedes 29. Dem weiteren UND-Glied 20 nachgeschaltet ist ein weiterer Eingang E29B des zusätzlichen ODER-Gliedes 29. Das zusätzliche UND-Glied 23 ist ausgangsseitig mit einem zusätzlichen Eingang E27C des weiteren ODER-Gliedes 27 verbunden. Ein Ausgang des weiteren ODER-Gliedes 27 bildet den weiteren Ausgang A7B der Steuereinheit 7', ein Ausgang des zusätzlichen ODER-Gliedes 29 den einen Ausgang A7A der Steuereinheit 7'. Im Gegensatz zu der Steuereinheit gemäß Figur 3 weist die Steuereinheit 7' gemäß Figur 6 den Toggleeingang T auf, der an einen zusätzlichen Eingang E23C des zusätzlichen UND-Gliedes 23 und an einen invertierenden Eingang E20C des weiteren UND-Gliedes 20 angeschlossen ist. Der Toggleeingang T ist - wie Figur 5 zeigt - über ein Toggle-Flip-Flop an die Lesesteuerleitung LL angeschlossen.

Die durch die Steuereinheit 7' gemäß Figur 6 realisierte logische Verknüpfung ist in der Tabelle in Figur 7 zusammengefaßt. Man erkennt, daß das Lesen von Daten (logische "1" auf der Kontrolleitung KL und damit an dem einen Steuereingang E7A der Steuereinheit 7') von einer logischen "1" an dem weiteren Steuereingang E7B der Steuereinheit 7' des jeweils angesprochenen, aktivierten Speichers und vom Potential am Toggleeingang T abhängt; und zwar wird der eine Speicher 3 gemäß Figur 5 gelesen, wenn am Toggleeingang T eine logische "0" anliegt, und es wird der weitere Speicher 5 gemäß Figur 5 gelesen, wenn am Toggleeingang T eine logische "1" anliegt. Bei den weiteren Betriebsarten, d. h. beim Schreiben von Daten oder beim ausschließlichen Lesen des weiteren Speichers 5 (logische "1" am zusätzlichen Steuereingang E7C der Steuereinheit 7'), entspricht die Funktionsweise der Steuereinheit 7' gemäß Figur 6 der Steuereinheit gemäß Figur 3.

Der Vorteil der Steuereinheit 7' gemäß Figur 6 besteht darin, daß der eine Speicher 3 und der weitere Speicher 5 abwechselnd ausgelesen werden können, wenn am Toggleeingang T das Potential entsprechend umgestellt wird; es wird also über den Toggleeingang T ermöglicht, entweder den einen Speicher 3 oder den weiteren Speicher 5 zum Auslesen zu aktivieren. Ist der Toggleeingang T beispielsweise über das Toggle-Flip-Flop FF an die Lesesteuerleitung LL gemäß Figur 5 angeschlossen, so wird nach jedem Lesevorgang der Speicher gewechselt, d. h. daß nach dem Auslesen des einen Speichers 3 anschließend der weitere Speicher 5 und nach dem Auslesen des weiteren Speichers 5 anschließend der eine Speicher 3 ausgelesen wird. Durch die Verknüpfung der Steuereinheit 7' mit der Lesesteuerleitung LL wird also ein automatisches Umschalten der beiden Speicher 3 und 5 jeweils nach jedem Lesevorgang ermöglicht, ohne daß der Mikroprozessor 1 belastet wird; dies führt zu einem erheblichen Geschwindigkeitsgewinn beim Auslesen des einen Speichers 3 und des weiteren Speichers 5. Die Steuereinheit 7' gemäß Figur 6 erkennt über ihren Toggleeingang T also jeden Lesevorgang einzeln und schaltet hardwaremäßig nach jedem Lesevorgang den zu aktivierenden Speicher um. Die einzelnen Lesevorgänge werden dabei an den Potentialänderungen auf der Lesesteuerleitung LL gemäß Figur 5 erkannt.

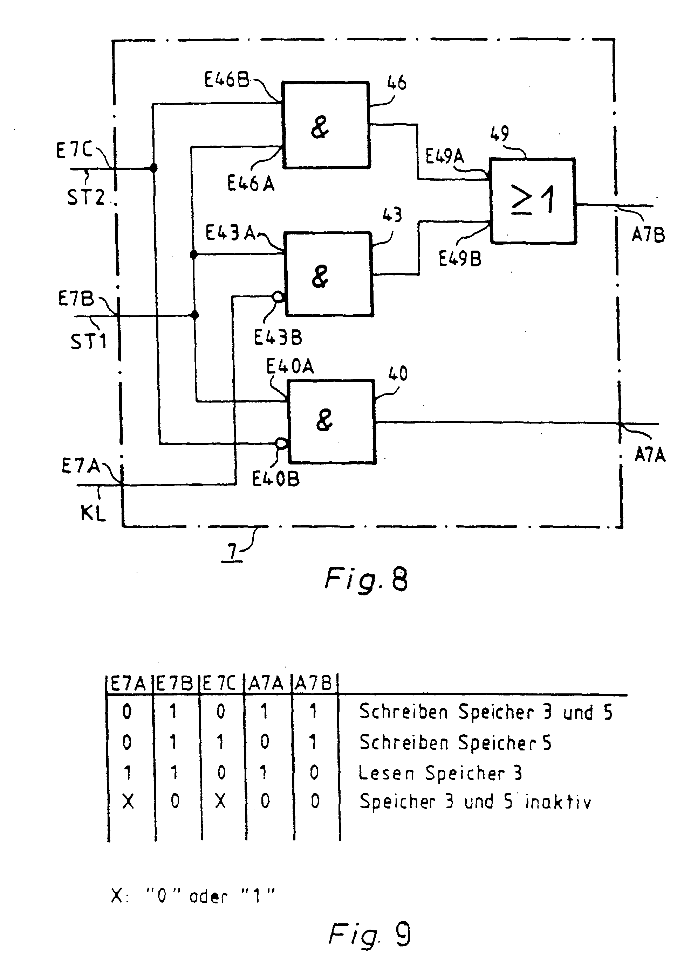

Figur 8 zeigt ein weiteres Ausführungsbeispiel einer Steuereinheit 7 für die Mikroprozessoranordnung gemäß Figur 2. Bei diesem weiteren Ausführungsbeispiel ist vorgesehen, daß der weitere Steuereingang E7B der Steuereinheit 7 an einen "memory chip select"-Ausgang des Mikroprozessors 1 und der zusätzliche Steuereingang E7C der Steuereinheit 7 an einen freiprogrammierbaren "output port"-Ausgang des Mikroprozessors 1 angeschlossen wird. Eine Anordnung wie die gemäß Figur 8 ist insbesondere dann erforderlich, wenn ein zweiter "memory chip select"-Ausgang des Mikroprozessor 1 nicht zur Verfügung steht.

Dem weiteren Steuereingang E7B der Steuereinheit 7 und damit der einen Steuerleitung ST1 ist ein UND-Gatter 40 mit einem Eingang E40A, ein weiteres UND-Gatter 43 mit einem Eingang E43A und ein zusätzliches UND-Gatter 46 mit einem Eingang E46A nachgeschaltet. Der zusätzliche Steuereingang E7C der Steuereinheit 7 und damit die weitere Steuerleitung ST2 sind an einen invertierenden Eingang E40B des einen UND-Gatters 40 und an einen weiteren Eingang E46B des zusätzlichen UND-Gatters 46 angeschlossen. Dem zusätzlichen UND-Gatter 46 ist ausgangsseitig ein Eingang E49A eines ODER-Gatters 49 nachgeordnet, dessen weiterer Eingang E49B mit einem Ausgang des weiteren UND-Gatters 43 verbunden ist. Der Ausgang des ODER-Gatters bildet den weiteren Ausgang A7B der Steuereinheit 7. Der eine Ausgang A7A der Steuereinheit 7 wird durch einen Ausgang des einen UND-Gatters 40 gebildet. Ein invertierender Eingang E43B des weiteren UND-Gatters. 43 ist mit dem einen Steuereingang E7A der Steuereinheit 7 und damit mit der Kontrolleitung KL verbunden.

Mit der Steuereinheit 7 gemäß Figur 8 wird eine logische Verknüpfung gemäß der Wahrheitstabelle in Figur 9 realisiert.

**Patentansprüche**

1.    Verfahren zum Erzeugen eines Fehlersignals zur Kennzeichnung eines Fehlers im Datenbestand des Speichers eines Mikrocomputers oder Mikroprozessors, bei dem die zu speichernden Daten in einen ersten freiprogrammierbaren Speicher (3) und in mindestens einen weiteren freiprogrammierbaren Speicher(5) eingelesen und zu einem späteren Zeitpunkt aus den beiden Speichern (3, 5) gelesen und miteinander verglichen werden, wobei bei Ungleichheit der Daten der beiden Speicher (3, 5) das Fehlersignal erzeugt wird, und bei dem den beiden Speichern (3, 5) zum Beschreiben mit den Daten von einer externen, an den Mikrocomputer/ Mikroprozessor (1) angeschlcssenen Steuereinheit (7) entsprechende Aktivierungssignale (S1, S2) zugeführt werden,
**dadurch gekennzeichnet,**
**daß** das Potential auf der Lesesteuerleitung (LL) eines Steuerbusses zwischen dem Mikrocomputer/ Mikroprozessor (1) und den Speichern (3, 5) von der Steuereinheit (7) auf einen Potentialwechsel hin überwacht wird und
die Potentialwechsel in der Steuereinheit (7) dahingehend ausgewertet werden, daß nach dem Lesen eines der beiden Speicher (3, 5) der jeweils andere der beiden Speicher (3, 5) mit einem Aktivierungssignal (S1, S2) beaufschlagt wird.

2. Verfahren nach Anspruch 1,
**dadurch gekennzeichnet,**
**daß** die Frequenz der Potentialwechsel auf der Lesesteuerleitung (LL) von mindestens einem zwischen der Steuereinheit (7) und der Lesesteuerleitung (LL) angeordneten Toggle-Flip-Flop herabgesetzt wird.

3. Verfahren nach Anspruch 1 oder 2,
**dadurch gekennzeichnet,**
**daß** die Steuereinheit (7) über mindestens einen "memory chip select"-Ausgang des Mikrocomputers/Mikroprozessors (1) von diesem angesteuert wird.

4. Verfahren nach einem der Ansprüche 1 bis 3,
**dadurch gekennzeichnet,**
**daß** die unter der Steuerung der Steuereinheit seriell gelesenen Daten der Speicher vom Mikrocomputer oder Mikroprozessor durch Vergleich auf inhaltliche Übereinstimmung/Abweichung untersucht werden.

5. Verfahren nach einem der Ansprüche 1 bis 4,
**dadurch gekennzeichnet,**
**daß** zu Prüfzwecken der Datenbestand eines Speichers gegenüber dem des anderen Speichers verändert und danach der Datenvergleich vorgenommen wird, wobei für den Fall, daß der Mikrocomputer/Mikroprozessor dabei inhaltlich übereinstimmende Daten erkennt, ein Fehlersignal ausgelöst wird.

6. Anordnung zum Erzeugen eines Fehlersignals zur Kennzeichnung eines Fehlers im Datenbestand des Speichers eines Mikrocomputers oder Mikroprozessors unter Verwendung eines freiprogrammierbaren ersten Speichers (3) und mindestens eines weiteren freiprogrammierbaren Speicher (5), wobei

- die beiden Speicher (3 ,5) über

  - einen Datenbus (DB) zum Übertragen von Datensignalen,
  - einen Adreßbus (AB) zum Übermitteln von Adreßsignalen und
  - einen Steuerbus (LL, SL) zum Übertragen von Steuersignalen mit dem Mikrocomputer/Mikroprozesscr (1) verbunden sind,

und wobei eine Steuereinheit (7) einerseits mit dem Mikrocomputer/Mikroprozessor (1) und andererseits mit den beiden Speichern (3, 5) verbunden und so eingerichtet ist, daß sie Aktivierungssignale (S1, S2) zum vorzugsweise gleichzeitigen Abspeichern von Daten in den Speichern (3, 5) an diese abgibt und wobei der Mikrocomputer/Mikroprozessor dazu eingerichtet ist, die einander entsprechenden Speicherplätze der beiden Speicher (3, 5) zu lesen und die gelesenen Daten auf inhaltliche Übereinstimmung zu prüfen,
**dadurch gekennzeichnet, daß**
die Steuereinheit (7) eingangsseitig an eine Lesesteuerleitung (LL) des Steuerbusses angeschlossen ist, und - veranlaßt durch einen dort dem Auslesen jeweils eines der beiden Speicher (3, 5) auftretenden Potentialwechsel - nach dem Auslesen des jeweils einen der beiden Speicher (3, 5) den jeweils anderen der beiden Speicher (3, 5) über entsprechende Aktivierungssignale (S1, S2) aktiviert.

7. Anordnung nach Anspruch 6,
**dadurch gekennzeichnet,**
**daß** die Steuereinheit (7) über eine Steuerleitung (ST1), eine weitere Steuerleitung (ST2) und eine Kontrolleitung (KL) an den Mikrocomputer/Mikroprozessor (1) angeschlossen ist.

8. Anordnung nach Anspruch 7,
**dadurch gekennzeichnet,**
**daß** mindestens eine der beiden Steuerleitungen (ST1, ST2) an einen "memory chip select"-Ausgang des Mikrocomputers/Mikroprozessors (1) angeschlossen ist.

9. Anordnung nach einem der Ansprüche 6 bis 8,
**dadurch gekennzeichnet, daß**

- die Steuereinheit (7) mindestens ein ODER-Glied (15), ein UND-Glied (13) und einen Inverter (11) enthält, wobei
- die eine Steuerleitung (ST1) mit einer Speicherauswahlleitung (SAL1) in Verbindung steht ;
- der Inverter (11) eingangsseitig mit der Kontrolleitung (KL) und ausgangsseitig mit einem Eingang (E13A) des UND-Gliedes (13) verbunden ist,
- ein weiterer Eingang (E13B) des UND-Gliedes (13) an die eine Steuerleitung (ST1) angeschlossen ist und
- dem UND-Glied (13) und der weiteren Steuerleitung (ST2) das ODER-Glied (15) nachgeschaltet ist, das ausgangsseitig an eine weitere Speicherauswahlleitung (SAL2) angeschlossen ist.

10. Anordnung nach einem der Ansprüche 6 bis 9,
**dadurch gekennzeichnet, daß**

- die Steuereinheit (7) an die Lesesteuerleitung (LL) des Steuerbusses über ein Toggle-Flip-Flop angeschlossen ist, das sein an die Steuereinheit (7) gerichtetes binäres Ausgangssignal nach jedem Potentialwechsel auf der Lesesteuerleitung (LL) ändert.

## Claims

1. Method for producing an error signal for identifying an error in the database in the memory of a microcomputer or microprocessor, in which the data to be stored is read to a first freely programmable memory (3) and to at least one further freely programmable memory (5) and is read from the two memories (3, 5) at a later time, with the two versions being compared with one another and with an error signal being produced if the data from the two memories (3, 5) do not match, and in which appropriate activation signals (S1, S2) are supplied to the two memories (3, 5) in order to write data to them from an external control unit (7) which is connected to the microcomputer/microprocessor (1), **characterized in that** the potential on the read control line (LL) of a control bus between the microcomputer/microprocessor (1) and the memories (3, 5) is monitored by the control unit (7) for a potential change, and the potential changes are evaluated in the control unit (7) such that, after reading of the two memories (3, 5), the respective other of the two memories (3, 5) has an activation signal (S1, S2) applied to it.

2. Method according to Claim 1, **characterized in that** the frequency of the potential changes on the read control line (LL) is reduced by at least one toggle flipflop, which is arranged between the control unit (7) and the read control line (LL).

3. Method according to Claim 1 or 2, **characterized in that** the control unit (7) is activated by the microcomputer/microprocessor (1), via at least one memory chip select output from the microcomputer/microprocessor (1).

4. Method according to one of Claims 1 to 3, **characterized in that** the data, which is read in serial form controlled by the control unit, in the memories is investigated by the microcomputer or microprocessor by comparison for a match/discrepancy in the contents.

5. Method according to one of Claims 1 to 4, **characterized in that**, for test purposes, the database of one memory is changed in comparison to that in the other memory, and the data comparison is carried out after this, with an error signal being initiated if the microcomputer/microprocessor in the process finds that the data contents match.

6. Arrangement for producing an error signal for identifying an error in the database in the memory of a microcomputer or microprocessor using a freely programmable first memory (3) and at least one further freely programmable memory (5), with the two memories (3, 5) being connected to the microcomputer/microprocessor (1) via

   - a databus (DB) for transmitting data signals,
   - an address bus (AB) for transmitting address signals, and
   - a control bus (LL, SL) for transmitting control signals,

   and with a control unit (7) being connected firstly to the microcomputer/microprocessor (1) and secondly to the two memories (3, 5), and being set up such that it emits activation signals (S1, S2) to the memories (3, 5) for preferably simultaneous storage of data in the memories (3, 5), and with the microcomputer/ microprocessor being set up to read the mutually corresponding memory locations in the two memories (3, 5) and to check that the contents of the read data match, **characterized in that** the control unit (7) is connected on the input side to a read control line (LL) of the control bus, and - initiated by a potential change that occurs there [lacuna] the reading of in each case one of the two memories (3, 5) - activates the respective other of the two memories (3, 5) via appropriate activation signals (S1, S2) once the respective one of the two memories (3, 5) has been read.

7. Arrangement according to Claim 6, **characterized in that** the control unit (7) is connected to the microcomputer/microprocessor (1) via a control line (ST1), a further control line (ST2) and a monitoring line (KL).

8. Arrangement according to Claim 7, **characterized in that** at least one of the two control lines (ST1, ST2) is connected to a memory chip select output of the microcomputer/microprocessor (1).

9. Arrangement according to one of Claims 6 to 8, **characterized in that**

   - the control unit (7) contains at least one OR gate (15), one AND gate (13) and one inverter (11), with
   - the one control line (ST1) being connected to a memory select line (SAL1) ;
   - the inverter (11) being connected on the input side to the monitoring line (KL) and on the output side to an input (E13A) of the AND gate (13),
   - a further input (E13B) of the AND gate (13) being connected to the control line (ST1), and

- the AND gate (13) and the further control line (ST2) being followed by the OR gate (15), which is connected on the output side to a further memory select line (SAL2).

10. Arrangement according to one of Claims 6 to 9, **characterized in that**

- the control unit (7) is connected to the read control line (LL) of the control bus via a toggle flip-flop, which changes its binary output signal, which is directed to the control unit (7), after each potential change on the read control line (LL).

**Revendications**

1. Procédé de production d'un signal d'erreur pour caractériser une erreur dans le stock de données de la mémoire d'un micro-ordinateur ou d'un microprocesseur, dans lequel les données à mettre en mémoire sont entrées dans une première mémoire (3) librement programmable et dans au moins une mémoire (5) supplémentaire librement programmable et sont lues dans les deux mémoires (3, 5) et comparées les unes aux autres à un instant ultérieur, le signal d'erreur étant produit en cas de non identité des données des deux mémoires (3, 5), et dans lequel il est envoyé aux deux mémoires (3, 5), pour l'écriture des données d'une unité (7) de commande externe, raccordée au micro-ordinateur/micro-processeur (1), des signaux (S1, S2) d'activation correspondant, **caractérisé en ce que** le potentiel sur la ligne (LL) de commande de lecture d'un bus de commande entre le micro-ordinateur/microprocesseur (1) et les mémoires (3, 5) est surveillé par l'unité (7) de commande pour déterminer un changement de potentiel et le changement de potentiel dans l'unité (7) de commande est exploité en vue d'alimenter après la lecture de l'une des deux mémoires (3, 5) en un signal (S1, S2) d'activation l'autre des deux mémoires (3, 5).

2. Procédé suivant la revendication 1, **caractérisé en ce que** la fréquence du changement de potentiel sur la ligne (LL) de commande de lecture est abaissée par au moins une bascule toggle-flip-flop montée entre l'unité (7) de commande et la ligne (LL) de commande de lecture.

3. Procédé suivant la revendication 1 ou 2, **caractérisé en ce que** l'unité (7) de commande est commandée par le micro-ordinateur/microprocesseur (1) par l'intermédiaire d'au moins une sortie "memory chip select" de celui-ci.

4. Procédé suivant l'une des revendications 1 à 3, **caractérisé en ce que** les données des mémoires lues de manière sérielle sous la commande de l'unité de commande sont inspectées par le micro-ordinateur ou le microprocesseur pour déterminer par comparaison une coïncidence/un écart de contenu.

5. Procédé suivant l'une des revendications 1 à 4, **caractérisé en ce qu'**à des fins de test, le stock de données d'une mémoire est modifié par rapport à celui de l'autre mémoire et il est procédé ensuite à la comparaison des données, un signal d'erreur étant déclenché dans le cas où le micro-ordinateur/microprocesseur détecte en l'occurrence des données coïncidant du point de vue du contenu.

6. Dispositif de production d'un signal d'erreur pour caractériser une erreur dans le stock de données de la mémoire d'un micro-ordinateur ou microprocesseur en utilisant une première mémoire (3) librement programmable et au moins une mémoire (5) supplémentaire librement programmable,

- les deux mémoires (3, 5) étant reliées

- par l'intermédiaire d'un bus (DB) de données pour la transmission de signaux de données,
- par l'intermédiaire d'un bus (AB) d'adresse pour la transmission de signaux d'adresse et
- par l'intermédiaire d'un bus (LL, SL) de commande pour la transmission de signaux de commande au micro-ordinateur/ microprocesseur (1),

et une unité (7) de commande étant reliée d'une part au micro-ordinateur/microprocesseur (1) et d'autre part aux deux mémoires (3, 5) et étant aménagée de telle manière qu'elle fournit aux mémoires (3, 5) des signaux (S1, S2) d'activation pour la mise en mémoire de préférence au même moment de données dans les mémoires (3, 5) et le micro-ordinateur/microprocesseur étant aménagé pour lire les emplacements de mémoire des deux mémoires (3, 5) qui se correspondent et pour vérifier que les données lues coïncident dans leur contenu,
**caractérisé en ce que** l'unité (7) de commande est raccordée côté entrée à une ligne (LL) de commande de lecture du bus de commande et

- d'une façon provoquée par un changement de potentiel y apparaissant lors de la lecture respectivement de l'une des deux mémoires (3, 5) - active après la lecture de respectivement l'une des deux mémoires (3, 5) respectivement à l'autre des deux mémoires (3, 5) par l'intermédiaire de signaux (S1, S2) d'activation correspondants.

7. Dispositif suivant la revendication 6, **caractérisé en ce que** l'unité (7) de commande est raccordée par l'intermédiaire d'une ligne (ST1) de commande, d'une ligne (ST2) de commande supplémentaire et d'une ligne (KL) de contrôle au micro-ordinateur/microprocesseur (1).

8. Dispositif suivant la revendication 7, **caractérisé en ce qu'**au moins l'une des deux lignes (ST1, ST2) de commande est raccordée à une sortie "memory chip select" du micro-ordinateur/microprocesseur (1).

9. Dispositif suivant l'une des revendications 6 à 8, **caractérisé en ce que**

  - l'unité (7) de commande comporte au moins un élément (15) OU, un élément (13) ET et un inverseur (11),
  - l'une (ST1) des lignes de commande est en liaison avec une ligne (SAL1) de sélection de mémoire ;
  - l'inverseur (11) est relié côté entrée à la ligne (KL) de contrôle et côté sortie à une entrée (E13A) de l'élément (13) ET,
  - une entrée (E13B) supplémentaire de l'élément (13) ET est raccordée à l'une (ST1) des lignes de commande et
  - il est monté en aval de l'élément (13) ET et de la ligne (ST2) de commande supplémentaire l'élément (15) OU qui est raccordé côté sortie à une ligne (SAL2) de sélection de mémoire supplémentaire.

10. Dispositif suivant l'une des revendications 6 à 9, **caractérisé en ce que**

  - l'unité (7) de commande est raccordée à la ligne (LL) de commande de lecture du bus de commande par l'intermédiaire d'une bascule toggle-flip-flop qui change son signal de sortie binaire dirigé vers l'unité (7) de commande après chaque changement de potentiel sur la ligne (LL) de commande de lecture.

Fig.1

Fig. 2

Fig. 3

13

| E7A | E7B | E7C | A7A | A7B | |
|-----|-----|-----|-----|-----|---|
| 0 | 1 | 0 | 1 | 1 | Schreiben Speicher 3 und 5 |
| 0 | 0 | 1 | 0 | 1 | Schreiben Speicher 5 |
| 1 | 1 | 0 | 1 | 0 | Lesen Speicher 3 |
| 1 | 0 | 1 | 0 | 1 | Lesen Speicher 5 |
| X | 0 | 0 | 0 | 0 | Speicher 3 und 5 nicht aktiviert |

X: "0" oder "1"

*Fig. 4*

*Fig. 5*

Fig. 6

| E7A | E7B | E7C | T | A7A | A7B | |
|-----|-----|-----|---|-----|-----|---|
| 0 | 1 | 0 | 0 | 1 | 1 | Schreiben Speicher 3 und 5 |
| 0 | 0 | 1 | 0 | 0 | 1 | Schreiben Speicher 5 |
| 0 | 1 | 0 | 1 | 1 | 1 | Schreiben Speicher 3 und 5 |
| 0 | 0 | 1 | 1 | 0 | 1 | Schreiben Speicher 5 |
| 1 | 1 | 0 | 0 | 1 | 0 | Lesen Speicher 3 |
| 1 | 0 | 1 | 0 | 0 | 1 | Lesen Speicher 5 |
| 1 | 1 | 0 | 1 | 0 | 1 | Lesen Speicher 5 |
| 1 | 0 | 1 | 1 | 0 | 1 | Lesen Speicher 5 |
| X | 0 | 0 | X | 0 | 0 | Speicher 3 und 5 nicht aktiviert |

X: "0" oder "1"

Fig. 7

Fig. 8

| E7A | E7B | E7C | A7A | A7B | |
|-----|-----|-----|-----|-----|---|
| 0 | 1 | 0 | 1 | 1 | Schreiben Speicher 3 und 5 |
| 0 | 1 | 1 | 0 | 1 | Schreiben Speicher 5 |
| 1 | 1 | 0 | 1 | 0 | Lesen Speicher 3 |
| X | 0 | X | 0 | 0 | Speicher 3 und 5 inaktiv |

X: "0" oder "1"

Fig. 9